(19) **Europäisches Patentamt / European Patent Office / Office européen des brevets**

(11) **EP 3 830 920 B1**

(12) **EUROPEAN PATENT SPECIFICATION**

(45) Date of publication and mention
of the grant of the patent:
**03.05.2023 Bulletin 2023/18**

(21) Application number: **19779959.6**

(22) Date of filing: **31.07.2019**

(51) International Patent Classification (IPC):
**H02H 1/04** *(2006.01)* **G01R 31/327** *(2006.01)*
**H02H 3/04** *(2006.01)* **H02H 3/05** *(2006.01)*

(52) Cooperative Patent Classification (CPC):
**H02H 1/04; G01R 19/2513; H02H 3/044;**
**H02H 3/05;** G01R 31/62

(86) International application number:
**PCT/IB2019/056527**

(87) International publication number:
**WO 2020/026163 (06.02.2020 Gazette 2020/06)**

(54) **A METHOD AND A DEVICE FOR SUPERVISION OF A VOLTAGE TRANSFORMER**

VERFAHREN UND VORRICHTUNG ZUR ÜBERWACHUNG EINES SPANNUNGSWANDLERS

PROCÉDÉ ET DISPOSITIF DE SUPERVISION D'UN TRANSFORMATEUR DE TENSION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.07.2018 IN 201841028750**

(43) Date of publication of application:
**09.06.2021 Bulletin 2021/23**

(73) Proprietor: **ABB Schweiz AG**
**5400 Baden (CH)**

(72) Inventors:
• **SUDHEER, B**
**Bangalore 560048 (IN)**

• **K, Ketan**
**Belagavi, Karnataka 590006 (IN)**
• **AHMED, M**
**Hyderabad, Telangana 500023 (IN)**
• **KUNAL, K**
**Noida, Uttar Pradesh 201309 (IN)**

(74) Representative: **Zimmermann & Partner**
**Patentanwälte mbB**
**Postfach 330 920**
**80069 München (DE)**

(56) References cited:
**WO-A1-2008/034400** **CN-A- 104 393 674**
**CN-B- 103 513 145** **JP-A- 2000 262 097**

**Description**

**FIELD OF THE INVENTION**

The present invention relates generally to the field of electrical power systems and more particularly to the field of supervising the secondary of a voltage transformer connected to a power line of an electrical power distribution system.

**BACKGROUND OF THE INVENTION**

In electrical power systems, electrical equipment are used for distribution of power. During operation of the electrical equipment, there is a requirement for protecting electrical equipment from getting stressed and failed due to fault conditions. The equipment are protected using protective components like protection relay devices/intelligent electronic devices (IEDs) that detect a fault condition and responds to the fault condition by electrically opening and closing portions of the power system i.e. the protection relay device can provide a trip signal on detection of the fault condition to operate a circuit breaker to electrically isolate the electrical equipment or a portion of the power system to protect the electrical equipment. It is well known that an LED can be configured for protection function or for other functions (e.g. supervisory function) as needed to carry out functions related to monitoring and control of electrical power network.

Voltage transformers (VT) are widely used in power systems for measurement of high voltages in an electrical line connecting to the power equipment that is being protected. A VT provides for measurement by stepping down voltage in the power line and accurately reproducing the high voltage observed at the primary side as a low voltage signal at the secondary side. It is important that the value of voltage in the power line is accurately represented by the voltage transformer since the operation of the protection relay is based on the voltage information. However, it is possible that failures may occur in the secondary side i.e. there may be a VT failure (e.g. short circuit at the secondary of the VT) that can result in a false information being relayed to the protection relay. For example, a distance protection function can mal-operate on account of such failure to correctly sense the voltage in power line as it would inaccurately infer an under voltage condition and trip the circuit breaker for protecting an electrical subsystem in an electrical power network.

Failure in secondary circuit of voltage transformer needs to be detected in an effective manner in order to avoid any unwanted operation. The efficient detection of failure of the secondary of VT can lead to timely blocking of protection functions associated with the VT signal by blocking a distance relay or protection relay from generating a trip signal to isolate a section of the power system or the electrical equipment being protected.

The detection of electrical faults (e.g. short circuit of secondary terminals) associated with voltage transformer can be carried out with a supervisory relay, also herein referred as voltage transformer secondary supervisory relay. Supervisory relay (also an Intelligent Electronic Device) can make the determination of electrical faults (and other faults) associated with voltage transformer or current transformers (instrument transformers) with help of measured signals (voltage/current) and provide a block signal (or status signal) to support with blocking trip actions carried out with protection relay/distance relay in response to incorrect detection of a fault in the electrical line/equipment.

For special applications like high speed motor bus transfer where due to loss of power in a main feeder, the motor loads are supplied power from a standby feeder, usually supervision of the secondary of VT need to take place within a small operating time to avoid unsafe transfer resulting in damage to motor loads. During a short circuit at the secondary of the VT, the protective means (e.g. fuse, miniature circuit breaker) is expected to operate. This condition of failure at the secondary and causing a fuse-failure (blown fuse) can be incorrectly sensed as an outage of a power generation source and could cause undesirable bus transfer resulting in unwanted stress to motor loads and contribute to damage to motor loads. Therefore, fuse-failure/miniature circuit breaker status detection is required to take place before bus transfer related action is initiated to ensure that the bus transfer action is being initiated in response to actual failure of a power generator unit or power supply and not resulting from the failure at the voltage transformer. In such applications like high speed bus transfer, therefore detection of failure of voltage transfer needs to be carried out in much reduced time to be able to timely operate circuit breakers to cause high speed bus transfer to avoid unnecessary stresses/damages to the motor loads and avoid interruption in power supply to the loads.

Also for some protection functions like under voltage function the operating time can be reduced, which gets explicitly delayed so that fuse failure operation time can be accommodated to sense failure at the secondary side of the VT if any before providing trip signal to operate a circuit breaker for protection. There are instances wherein wrong detection of fuse failure have taken place leading to blocking of protection function. Such instances can be effective addressed with a fast and reliable detection of a fault condition to properly provide protection function.

Hence, there is a need for effective (reliable and fast) supervision of the secondary of VT, that can accurately distinguish between a failure at the secondary (leading to fuse failure) of the VT from an actual power system fault requiring protection device to operate fast and reliably.

WO 2008/034400 A1 relates to a method for producing a fault signal, which indicates a fault in the secondary circuit of a current transformer, which interacts with a local differential protective device, which monitors a section end of an electrical energy supply system, wherein in the method, measured current values which are detected by the current transformer and indicate a current flowing through the section end are monitored by the local differential protective device, and a suspicion signal is produced if the absolute values of successive measured current values drop suddenly, and the fault signal is produced if the suspicion signal is present. In order to be able to identify a fault in a secondary current transformer circuit even more reliably with such a method, the invention proposes that a first reset signal is produced by the local differential protective device if comparison measured current values, which are detected at the time at which the suspicion signal is produced in at least one remote differential protective device, which monitors a further section end of the electrical energy supply system, likewise drop suddenly in terms of their absolute values, and the fault signal is blocked if the first reset signal is present. The invention also relates to a correspondingly designed differential protective device.

CN 103 513 145 B discloses a method for detection the disconnection in the secondary side of a current transformer. CN 104 393 674 A also discloses a method for monitoring of instrumental transformers (CTs VTs).

JP 2000 262097 A discloses a method for preventing the erroneous stopping of an AC generator based on voltage and current measurements of the line the generator provide power to. In addition, the device determines the fault status on the secondary side of a voltage transformer providing said voltage measurements.

## SUMMARY

The above-mentioned shortcomings, disadvantages and problems are addressed herein which will be understood by reading and understanding the following specification.

The present invention provides a method in accordance with the appended claim 1 for supervising a voltage transformer and operating at least one circuit breaker. The method is based on a blocking signal from a supervisory relay, the at least one circuit is electrically connected to a protection relay in a power distribution system. The power distribution system comprising a plurality of electrical power distribution components. The supervisory relay being interfaced with at least one voltage transformer and at least one current transformer, the at least one voltage transformer and the at least one current transformer are connected to a power line of the power distribution system, the method comprising, the supervisory relay: receiving at least one voltage signal from the voltage transformer and at least one current signal from the current transformer; calculating with at least two voltage functions a voltage fault status based on the received voltage signal; calculating with at least one current function a current fault status based on the received current signal; determining a health condition of the power line based on voltage fault status and current fault status; wherein the health condition being one of a) a fault in the power line, and b) a disturbance in a secondary of the voltage transformer; and generating a block signal for blocking generation of trip signal by the protection relay to operate the circuit breaker based on determined health condition being that of the disturbance in the secondary of the voltage transformer.

In an embodiment of the present invention, calculating any of the voltage fault status or the current fault status includes computing a representative magnitude value of the at least one voltage signal or the at least one current signal and comparing a difference between the computed representative magnitude value in a first half cycle with that of the subsequent half cycle, with a pre-defined threshold, wherein the representative magnitude value is a root mean square value.

In another embodiment of the present invention, determining a health condition of the power line comprises consolidating the voltage fault status from the at least two voltage function and the current fault status from the at least one current function, wherein at least one voltage function from the at least two voltage functions is provided with a higher weightage for determining the health condition of the power line.

In another aspect, the present invention provides in accordance with the appended independent claim 4 a system comprising a supervisory relay for supervising a voltage transformer.

In an embodiment of the present invention, the supervisory relay is a virtual device configured in the protection relay.

In an embodiment of the present invention, wherein one voltage function from the at least two voltage functions and the at least one current function is based on determination of root mean square value.

## BRIEF DESCRIPTION OF DRAWINGS

The appended drawings illustrate exemplary embodiments as disclosed herein, and are not to be considered limiting in scope. In the drawings:

　　Figure 1 is a block diagram showing the components and their connections for protection of electrical equipment/load in an electrical network with a protection relay;
　　Figure 2 is a block diagram showing the functional elements for performing the method of the present invention;

Figure 2a is a logic diagram for determining the disturbance in the voltage signal;
Figure 2b is a logic diagram for determining the fault status in the power line; and
Figure 3 shows the flow diagram of the method for supervision of circuit connected to secondary of the voltage transformer.

## DETAILED DESCRIPTION

The present invention is related to a method for determining a health condition of a power line and to distinguish if there is a fault in the power line or there is a disturbance in the secondary of the voltage transformer (VT) with an IED. The present invention discloses a reliable method of supervising the secondary circuit of VT with additional information from current transformer (CT). The method can be performed by an IED that can be configured as a separate supervisory relay and also can be configured to have supervisory functions together with protection function in a protection relay for protecting equipment connected in an electrical network, in which case the protection relay also acts as a virtual supervisory relay (the supervisory functions are configured in the protection relay). In this context of the invention, supervisory relay therefore can be provided as a separate device or as a virtual device comprised in the protection relay. The invention combines functions related to voltage and current to evaluate the health condition of the power line and reliably distinguishes between a disturbance condition (e.g. a short circuit condition, fuse failure condition) in the VT secondary and an actual fault in the power line.

In the following detailed description, reference is made to the accompanying drawings that form a part hereof, and in which is shown by way of illustration specific embodiments, which may be practiced. These embodiments are described in sufficient detail to enable those skilled in the art to practice the embodiments, and it is to be understood that other embodiments may be utilized. The following detailed description is, therefore, not to be taken in a limiting sense.

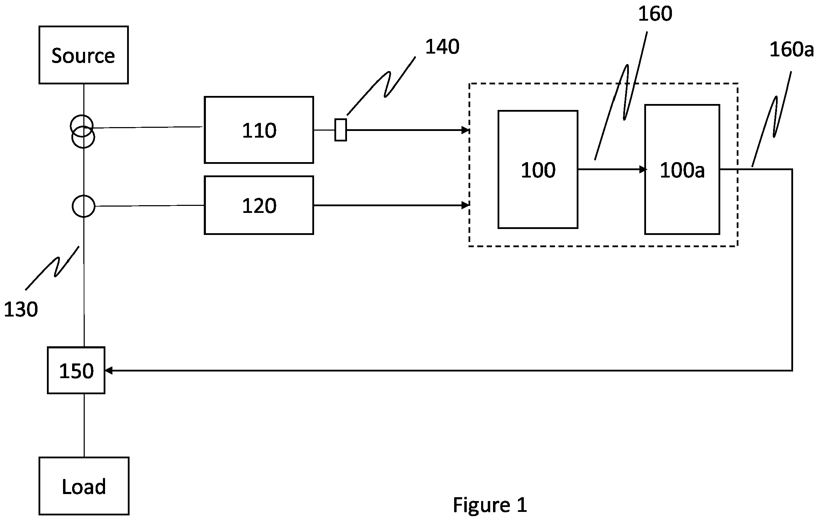

Figure 1 is a schematic diagram showing electrical components/equipment and their connections for protection of electrical equipment/load or electrical substation (line protection) in a power distribution system with a protection relay (100a) and supported with a supervisory relay (100). The supervisory relay function can be comprised in a protection relay device (100a), however in the Figure 1 these are shown separately. For the purpose of protection or for determination of disturbance in the voltage secondary, both the devices, protection relay and supervisory relay are interfaced with the VT 110 and CT 120 for obtaining measurable values of voltage and current in the power line 130 for processing related to accurate/reliable fault detection. The secondary side of the VT 110 is shown to be provided with a fuse 140 for protection against accidental short circuit of the secondary terminals of the VT. The fuse 140 is provided for protecting the secondary circuit of the potential transformer, which delivers the stepped down voltage for measurement by the supervisory relay 100, protection relay 100a and also for voltmeters (not shown in the figure). When there is a problem with the secondary circuit of the VT 110, which delivers an analog signal to the protection relay 100a will identify the problem as an under voltage situation and could trip the circuit-breaker 150 to protect loads connected from the source via the power line 130. The circuit breaker 150 is electrically connected in the power distribution system and the power distribution system can have other electrical power distribution components (load/line). Detection of a disturbance (e.g. reduction in voltage levels) can result due to actual under voltage condition or disturbance in the secondary side/circuit of the VT, and is required to be accurately distinguished, and for this purpose, a supervisory relay (an IED configured with supervisory functions), 100 is provided (Figure 1). The supervisory relay provides a block signal (160) as its output that can be used by protection relay to provide a trip signal (160a) only when there is a fault in the electrical line/equipment. The protection relay 100a blocks generation of trip signal when there is a fault with the instrument transformer.

In this embodiment, the supervision of the secondary of the VT is carried out by an independent supervisory relay device 100 which is different from the protection relay that generates the trip signal for operating the circuit breaker. Here, the relay for supervising secondary of VT produces a block signal 160a for use by the protection relay 100a to block the trip signal generated by under-voltage protection functions, thereby ensuring that there is no mal-operation during failure of the secondary of the VT.

In another embodiment, the supervisory function carried out by the supervisory relay, 100 can be integral part of the protection relay 100a. Here, the protection relay 100a detects failures related to voltage transformer using the supervisory functions configured in the protection relay (IED) and generates a block status/signal that are used further by the protection relay to block generation of trip signals caused by under-voltage protection functions.

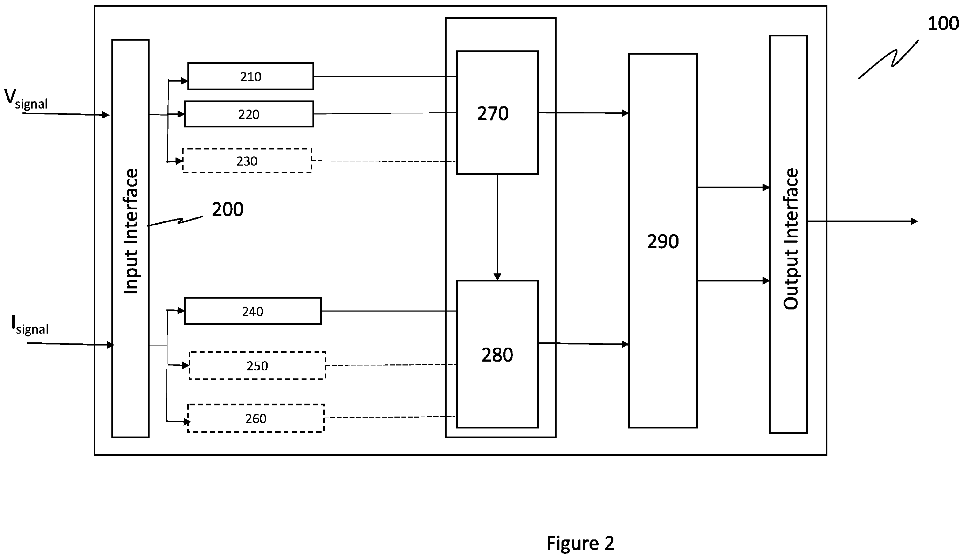

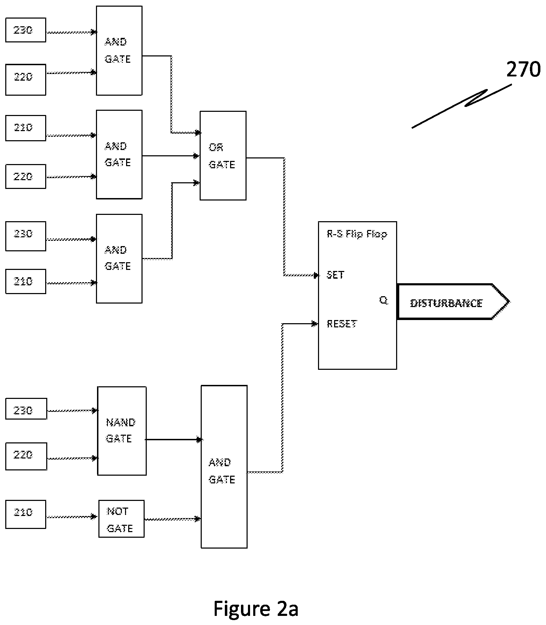

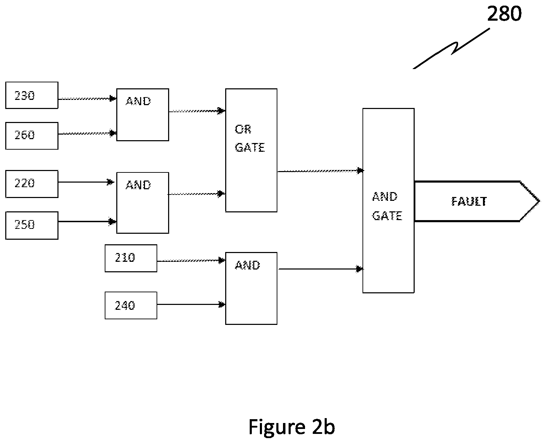

Figure 2 is a block diagram showing the functional elements for reliably distinguish between a disturbance/fault condition at the secondary side/circuit of the VT and actual fault (e.g. under voltage detection at the main power line) by the supervisory relay 100 and to support operating the circuit breaker with the protection relay 100a on detection of actual fault. The supervisory relay 100 comprises an input interface 200 to receive voltage signal from the VT and current signal from the CT, and the VT and CT are connected to the power line. The input interface provides for signal conditioning as needed along with digitization of the signals with analog to digital convertor for further processing of the signals.

The supervisory relay comprises functions for evaluating the current signal and voltage signal received from the CT and VT for detection of variations in the signal that can be caused by disturbances and fault conditions arising in the power system. Figure 2 depicts an exemplary case where three voltage functions 210, 220 and 230 are shown. Each of the voltage functions perform evaluation of the received voltage signals to determine a voltage fault status or to detect for any disturbance in the voltage signal coming from the VT by using a mathematical function that is different from the others to reliably detect and distinguish between a fault condition and failure at the secondary of the instrument transfer (VT). More than one voltage functions are used to improve reliability of such detection. In the exemplary case, at least two voltage functions are said to be deployed for reliably detecting variations in the voltage signal and for further determinations of actual fault conditions based on two or more such parallel detection of variations in the voltage signal.

The supervisory relay also comprises means for measuring current signal and for detecting variations in the current signal using current functions, 240, 250 and 260 to evaluate the current signal received from the CT and determine a fault status of the current signal. Here, for reliably distinguishing an actual fault condition and disturbance caused due to voltage transformer, at least one current function need to be used to detect if there is any corresponding variations also detected in the current signal to that detected in the voltage signal to distinguish cause of such variations as being actual fault.

The output of voltage functions 210, 220 and 230 can be an indicative disturbance status arrived at from processing of the voltage signal to detect variations and to determine if these variations are within an preset acceptable level (e.g. 10% or 15% variations from a nominal value provided or as a limit set with upper/lower thresholds). Each of the voltage functions, therefore has a means to evaluate the signal to detect deviations from the normal (healthy) state from the voltage signal (magnitude/shape parameters) and carry out comparisons using threshold values (including over time- presence of variations for certain duration/AC cycle time) to identify a disturbance condition. All the individual outputs are logically combined in a disturbance unit 270 to provide a consolidated output indicating the voltage fault status to indicate presence of disturbance in the voltage signal.

In an embodiment, the output of the three voltage functions are consolidated such that, if two out of the three voltage functions provide a certain output, then that output is taken as the actual result for determining the status of disturbance in the voltage signal. In yet another embodiment, any one of the voltage functions can be given more weightage (as essential signal and used with an 'AND' logical function for consolidating signals) in compared to the other functions (using 'OR' logical function to combine signals), such that, output from the high weight function is considered as more important in deciding the status of the disturbance in the signal with appropriate logical combinations using "OR" and "AND" functions and to evaluate the consolidated output.

In this exemplary embodiment, the disturbance unit 270 provides a positive disturbance output, that is, disturbance exists in the voltage signal if two voltage functions 210 and 220 provide a positive disturbance output. If there are more than two voltage functions for evaluating the received voltage signal, the disturbance unit 270 provides a positive disturbance output, that is, disturbance exists in the voltage signal if at least two of the three voltage functions out of three voltage functions provide a positive disturbance output.

Figure 2a is a logic diagram for determining the disturbance in the voltage signal. Figure 2a shows an exemplary logic diagram applied for disturbance unit 270. In this logic diagram, output for disturbance detected by all the voltage functions 210, 220 and 230 are combined in a manner such that, if two of the voltage functions have a positive output (existence of disturbance in the received voltage signal), then the consolidated disturbance output is also positive. The logical combinations of the signals can be combined in several manner to obtain a voltage fault status (disturbance status). Such logical combinations can also be combined to set and reset the disturbance status signal with a flip flop logic (as shown in Figure 2a).

In this exemplary case with three current functions, the current functions 240, 250 and 260 evaluates the received current signal to determine existence of any abnormality in the current signal and provides a current fault status individually from each of the current functions.

The current fault status are consolidated in a current fault unit 280, wherein the consolidated output for disturbance is received from the disturbance unit 270 and the individual current fault statuses from each of the current functions are evaluated. The current fault status unit 280 provides a positive fault signal or indicates that fault exists in the power line based on determining if there is an abnormality in the current signal and a positive disturbance output received from the disturbance unit 270. The fault status output for 280 is high if the current fault status output from 240 is high and also the disturbance output from 270 is high. The fault status output for 280 is low in case only disturbance output from 270 is received as high but the fault in current signal status received from the current functions 240, 250 or 260 is low.

In an exemplary embodiment, the current functions may have different weightage in terms of ascertaining the status of fault in the signal from the power line. For example, only a single current function output may be used by the current fault unit 280 for comparison with disturbance output from 280. In another exemplary embodiment, two current functions maybe utilized to evaluate the presence of fault in the signal from the power line. In yet another embodiment, there maybe three current functions being utilized by 280 to evaluate presence of fault and a higher weightage can be given to any one of the current functions, that is, in case output of one current function is low, then even if the other two current functions provide a high output, the final output would be considered as low, since the higher weightage is given to one such current function. For the purpose of the invention, at least one current function is needed to reliably detect disturbance in current signal and distinguish the actual fault condition. More than one current function can be used to improve reliability of detection of disturbance and fault conditions.

Figure 2b is a logic diagram for determining the fault status in the power line. Figure 2b shows an exemplary logic diagram that can be applied for the current fault status block 280 for determining the fault in the power line. The output from the voltage functions 210, 220 and 230 are combined with the output from the current functions 240, 250 and 260, such that a reliable output for fault is obtained. The logic diagram shown in Figure 2b is applied such that, one of a voltage function and a current function are provided more weightage. Here, in this example the voltage function 210 and the current function 240 are given more weightage in comparison to the other voltage functions and current functions such that the fault output is high only when output from voltage function 210 and current function 240 are high, and for improving reliability the combination is made with any one of the combinations of the remaining voltage functions (220, 230) and current function (250, 260).

The supervisory relay is also comprising a logic unit 290 which receives input from disturbance unit 270 and current fault unit 280, where the health condition of the power line is determined based on voltage fault status and current fault status as received from the disturbance unit 270 and current fault unit 280. The health condition is evaluated by the logic unit 290 as being one of the power line having a fault condition or only the VT secondary circuit having a disturbance. An output interface is provided in the supervisory relay to provide status signals that can be used to electronically communicate the disturbance/fault condition to other devices as needed, e.g. to operate the circuit breaker on determination of fault in the power line or for blocking trip function in the protection relay or for proper coordination with other devices that may be carrying out trip functions based on detected under voltage condition (disturbance) so that unwanted power outage condition can be avoided. Thus, an output signal from the supervisory relay (also protection relay when supervisory functions are included in the protection relay) can be used to operate the circuit breaker or to trigger an alarm or as a status signal in case only a disturbance output is detected as high (i.e. a disturbance condition in the voltage transformer).

The logic unit generates an output signal for operating the circuit breaker on determined health condition being that of the fault in the power line and for blocking operation of the circuit breaker on determined health condition being that of the disturbance in the secondary of the voltage transformer. The logic unit 290 generates a signal to block protection functions expected to give unwanted tripping, when there is no actual fault in the power line but only a disturbance in the secondary of the VT.

The present invention provides for reliable supervision of VT secondary supervision and also for special applications like high speed motor bus transfer. Residual voltage bus transfer requires faster VT secondary supervision, about half a cycle to avoid unsafe transfer resulting in damage to motor loads. For bus transfer application, residual transfer is done within 10ms after the voltage drops below a settable limit.

In an exemplary embodiment the voltage function 210 is a function that works by computing rate of change of voltage based on zero crossing detection. Every half cycle, root mean square (RMS) voltage is computed between a detected zero crossing and a previous zero crossing. Whenever there is an abrupt change, above a pre-defined threshold, between the computed RMS voltages from one zero crossing to another, a flag for fuse failure/fault case is raised. If a1, a2... aN are the voltage sample magnitudes between two zero crossings and N is the number of voltage samples between two zero crossings. Then half cycle RMS voltage is calculated as shown in equation below:

$$\text{calculated Rms Value} = \sqrt{\frac{(a_1^2 + a_2^2 ... + a_N^2)}{N}}$$

The above function detects disturbances in voltages either because of faults or fuse failure. To reliably differentiate between faults and fuse failure, the same function (Root Mean Square value determination as a representative magnitude value) is also performed for corresponding current channel, as indicated by block 240 in Figure 2

In another exemplary embodiment, the voltage function 220 works on the principle of symmetrical repetition of patterns in sinusoidal curve. A representative full cycle voltage samples are stored in a buffer. This buffer is continuously updated by new samples replacing old samples such that a recent one full cycle representative samples are available. This full cycle samples are divided into 2n parts, 'n' is selected such that there are integer number of samples in each part. In case of non-integer samples resulting either due to sampling rate or running frequency the entire cycle can be interpolated to get the desired integer samples. For each part, a value of standard deviation using the samples in the part is computed and then the values of standard deviations are compared with its corresponding symmetric (mirror) part in the full alternating current (AC) cycle. Whenever there is an abrupt change, outside a defined threshold, a flag for fuse failure/fault case is raised. As mentioned, samples for every semi-quarter cycle are stored in separate buffers. In a power cycle, there are 8 buffers, each containing 4 samples of voltage. Standard Deviation (SD) of samples in each buffer is then computed. Further, ratio of SD of symmetric buffers is computed and compared with the settable band. For example in the case as below:

- Sampling Frequency=1.6 kHz

- Number of Samples per power cycle = 32

- Number of Samples in each Buffer = 4

- Number of Buffers in each power cycle = 8 (i.e. AC cycle is divided in regions/phases marked as a, b, c, d, e, f, g and h, each region covering 45 degree phase region starting from positive zero crossing to cover the full AC cycle of 360 degree)

- Under normal conditions: symmetric buffer pairs are: {a,e}, {b,f}, {c,g}, {d,h}

Ratio of Standard Deviations of symmetric buffers is close to unity or within a settable band (for example- 0.85 to 1.15). This computation is repeated for subsequent cycles to continuously detect deviations from the normal/healthy state. To reliably differentiate between faults and fuse failure, the same function is also performed for corresponding current channel, as indicated by block 250 in Figure 2.

In another exemplary embodiment, the voltage function 230 works by comparing instantaneous values of voltage signal to corresponding voltage values of voltage signal for the immediate previous signal. Further, percentage rate of change of these values will be computed in order to demarcate the fuse failure (blown fuse) from other cases, if percentage rate of change is consistent (99-101 percent) for at least three consecutive instantaneous values. In healthy condition the percentage rate of change will be close to zero. This function will raise the flag for fuse failure/fault case within 5ms approximately. The steps for evaluation for voltage function 230 is listed below:

1. Samples (Instantaneous values) corresponding to every power cycle are stored in separate buffers.
2. Percentage rate of change of the sample of a cycle is calculated with respect to sample value of previous cycle.
3. If three such consecutive percentage rate of change values are within (99.5 to 100.5) %, we can say the case is of Fuse-failure.
4. To distinguish the fuse-failure from power-system faults, same computation is done over current signal.

If percentage rate of change (PROC) calculate for voltage samples are within a settable band or a threshold value for example, +15% and for current samples for example, +10% then the system is healthy. If PROC for three consecutive voltage samples are outside the healthy band, then an internal output for disturbance high will be activated. If PROC for three consecutive current samples are also outside the healthy band, then an internal output fault high will be activated. To reliably differentiate between faults and fuse failure, the same function is also performed for corresponding current channel, as indicated by block 260 in Figure 2.

Thus, it is illustrated that various techniques (voltage/current functions) can be used for detection of variations in the voltage and current signals. As more than one function (voltage function, current function) is being used for determination of fault, the method provides for improved reliability. Also, as each of the function provides a different technique for determination of variations, some of the techniques being computationally faster to perform, with suitable logical combination, faster response or early indications can be obtained about actual fault condition.

Thus, reliable and fast detection of actual fault and disturbance at the secondary of instrument transformer can be provided.

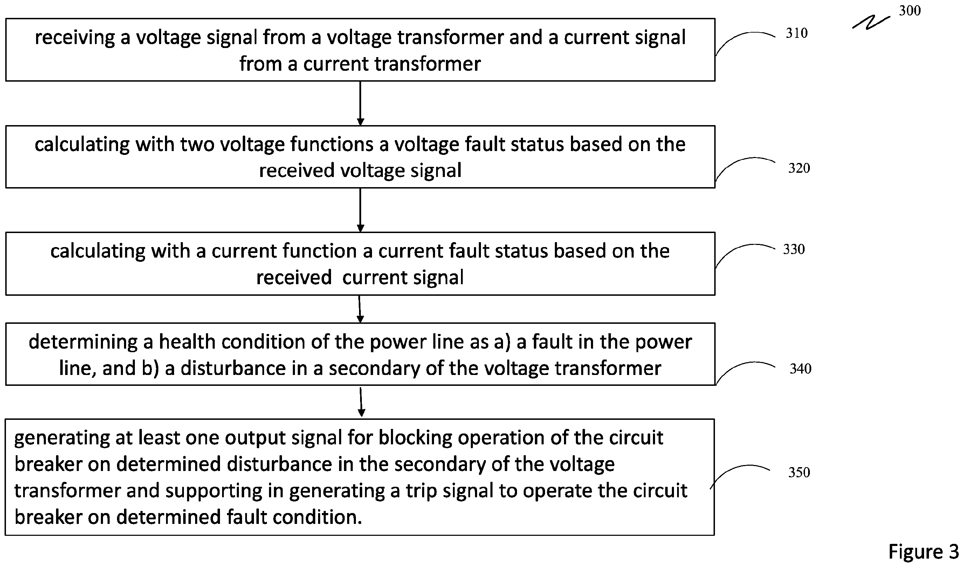

Figure 3 summarizes the method for operating the circuit breaker by a protection relay based on a blocking signal generated by a supervisory relay (or a supervisory function in the protection relay). As shown in step 310, the method comprises the supervisory relay receiving a voltage signal from the voltage transformer and a current signal from the current transformer. As shown in step 320, the method comprises calculating with at least two voltage functions a voltage fault status based on the received voltage signal. And as shown in step 330, a current fault status based on the received current signal is calculated with a current function. Then, as shown in step 340, determining a health condition of the power line based on voltage fault status and current fault status; wherein the health condition being one of a) a fault in the power line, and b) a disturbance in a secondary of the voltage transformer. And finally as shown in step 350, generating at least one output signal for blocking operation of the circuit breaker on determined health condition being that of the disturbance in the secondary of the voltage transformer and for supporting protection relay in operating the circuit breaker on determined health condition being that of the fault in the power line are provided.

This written description uses examples to describe the subject matter herein, including the best mode, and also to enable any person skilled in the art to make and use the subject matter. The patentable scope of the subject matter is defined by the claims.

**Claims**

1. A method for supervising an instrument voltage transformer (VT, 110) and operating at least one circuit breaker (150) based on a blocking signal from a supervisory relay (100), the at least one circuit breaker electrically connected to a protection relay (100a) in a power distribution system comprising a plurality of electrical power distribution components, the supervisory relay being interfaced with the VT and an instrument current transformer (CT), wherein the VT and the CT are connected to a power line (130) of the power distribution system to measure the voltage and the current on the power line, respectively, the method comprising the supervisory relay executing:

   receiving a voltage signal from the VT and a current signal from the CT;
   calculating with at least two different voltage functions (210, 220, 230) a voltage fault status based on the received voltage signal;
   calculating with at least one current function (240, 250, 260) a current fault status based on the received current signal;
   determining a health condition of the power line based on the voltage fault status and the current fault status;
   wherein the health condition being one of a fault in the power line and a disturbance in a secondary side of the voltage transformer; and
   generating a block signal for blocking generation of trip signal by the protection relay to operate the circuit breaker based on the determined health condition being that of the disturbance in the secondary side of the VT.

2. The method as claimed in claim 1, wherein calculating any of the voltage fault status or the current fault status includes computing a representative magnitude value of the at least one voltage signal or the at least one current signal and comparing a difference between the computed representative magnitude value in a first half cycle with that of the subsequent half cycle, with a pre-defined threshold, wherein the representative magnitude value is a root mean square value.

3. The method as claimed in one of the previous claims, wherein determining a health condition of the power line comprises consolidating the voltage fault status from the at least two voltage function and the current fault status from the at least one current function, wherein at least one voltage function from the at least two voltage functions is provided with a higher weightage for determining the health condition of the power line.

4. A system comprising:

   a power line (130),
   a circuit breaker (150) connected in the power line,
   an instrument voltage transformer (VT, 110) arranged to measure the voltage on the power line,
   an instrument current transformer (CT, 120) arranged to measure the current on the power line,
   a protection relay (100a) and a supervising relay (100), both connected to the secondary side of the VT and the CT,
   the protection relay generates a trip signal for operating the circuit breaker based on the received signals from the VT,
   the supervising relay generates a trip block signal based on the received signals from the VT and the CT,
   the supervisory relay being suitable for supervising the VT and providing a blocking signal to operate the circuit breaker electrically connected in the power line of a power distribution system by the protection relay, the supervisory relay comprising:

      an input interface (200) to receive at least one voltage signal from the VT and at least one current signal from the CT;
      a processing unit configured to determine:

         a) a voltage fault status based on the received voltage signal using at least two voltage functions (210, 220, 230);
         b) a current fault status based on the received current signal using at least one current function (240, 250, 260);
         c) a health condition of the power line based on the voltage fault status and the current fault status using a logic function; wherein the health condition being one of: a fault in the power line and a disturbance in a secondary side of the VT;

an output interface to generate a block signal for blocking generation of trip signal by the protection relay to operate the circuit breaker based on determined health condition being that of the disturbance in the secondary side of the VT.

5. The supervisory relay as claimed in claim 4, wherein the supervisory relay is a virtual device configured in the protection relay.

6. The supervisory relay as claimed in claim 4 or 5, wherein one voltage function from the at least two voltage functions and the at least one current function is based on determination of root mean square value.

**Patentansprüche**

1. Verfahren zum Überwachen eines Messspannungswandlers (VT, 110) und zum Betreiben mindestens eines Leistungsschalters (150) auf der Grundlage eines Blockiersignals von einem Überwachungsrelais (100), wobei der mindestens eine Leistungsschalter elektrisch mit einem Schutzrelais (100a) in einem Energieverteilungssystem verbunden ist, das eine Vielzahl von elektrischen Energieverteilungskomponenten umfasst, wobei das Überwachungsrelais mit dem VT und einem Messstromwandler (CT) verbunden ist, wobei der VT und der CT mit einer Stromleitung (130) des Energieverteilungssystems verbunden sind, um die Spannung bzw. den Strom auf der Stromleitung zu messen, wobei das Verfahren beinhaltet, dass das Überwachungsrelais Folgendes ausführt:

Empfangen eines Spannungssignals vom VT und eines Stromsignals vom CT;
Berechnen, mit mindestens zwei verschiedenen Spannungsfunktionen (210, 220, 230), eines Spannungsfehlerstatus auf der Grundlage des empfangenen Spannungssignals;
Berechnen, mit mindestens einer Stromfunktion (240, 250, 260), eines Stromfehlerstatus auf der Grundlage des empfangenen Stromsignals;
Bestimmen eines Gesundheitszustands der Stromleitung auf der Grundlage des Spannungsfehlerstatus und des Stromfehlerstatus;
wobei der Gesundheitszustand entweder ein Fehler in der Stromleitung oder eine Störung auf einer Sekundärseite des Spannungswandlers ist; und
Erzeugen eines Blockiersignals zum Blockieren der Erzeugung eines Auslösesignals durch das Schutzrelais, um den Leistungsschalter auf der Grundlage des ermittelten Gesundheitszustands der Störung auf der Sekundärseite des VT auszulösen.

2. Verfahren nach Anspruch 1, wobei das Berechnen des Spannungsfehlerstatus oder des Stromfehlerstatus das Berechnen eines repräsentativen Größenwerts des mindestens einen Spannungssignals oder des mindestens einen Stromsignals und das Vergleichen einer Differenz zwischen dem berechneten repräsentativen Größenwert in einem ersten Halbzyklus und dem des nachfolgenden Halbzyklus mit einem vordefinierten Schwellenwert umfasst, wobei der repräsentative Größenwert ein quadratischer Mittelwert ist.

3. Verfahren nach einem der vorhergehenden Ansprüche, wobei das Bestimmen eines Gesundheitszustands der Stromleitung das Zusammenführen des Spannungsfehlerstatus aus den mindestens zwei Spannungsfunktionen und des Stromfehlerstatus aus der mindestens einen Stromfunktion umfasst, wobei mindestens eine Spannungsfunktion aus den mindestens zwei Spannungsfunktionen mit einer höheren Gewichtung für die Bestimmung des Gesundheitszustands der Stromleitung versehen wird.

4. System, das Folgendes umfasst:

eine Stromleitung (130),
einen in die Stromleitung geschalteten Leistungsschalter (150),
einen Messspannungswandler (VT, 110), der zum Messen der Spannung auf der Stromleitung angeordnet ist,
einen Messstromwandler (CT, 120), der zum Messen des Stroms auf der Stromleitung angeordnet ist,
ein Schutzrelais (100a) und ein Überwachungsrelais (100), die beide an die Sekundärseite des VT und des CT angeschlossen sind,
wobei das Schutzrelais ein Auslösesignal zur Betätigung des Leistungsschalters auf der Grundlage der vom VT empfangenen Signale erzeugt,

wobei das Überwachungsrelais ein Auslösesperrsignal auf der Grundlage der vom VT und CT empfangenen Signale erzeugt,

wobei das Überwachungsrelais geeignet ist, den VT zu überwachen und ein Blockiersignal zu liefern, um den Leistungsschalter zu betätigen, der durch das Schutzrelais elektrisch in die Stromleitung eines Energieverteilungssystems geschaltet ist, wobei das Überwachungsrelais Folgendes umfasst:

eine Eingangsschnittstelle (200) zum Empfangen mindestens eines Spannungssignals vom VT und mindestens eines Stromsignals vom CT;
eine Verarbeitungseinheit, die konfiguriert ist, um Folgendes zu bestimmen:

a) einen Spannungsfehlerstatus auf der Grundlage des empfangenen Spannungssignals unter Verwendung von mindestens zwei Spannungsfunktionen (210, 220, 230);
b) einen Stromfehlerstatus auf der Grundlage des empfangenen Stromsignals unter Verwendung mindestens einer Stromfunktion (240, 250, 260) ;
c) einen Gesundheitszustand der Stromleitung auf der Grundlage des Spannungsfehlerstatus und des Stromfehlerstatus unter Verwendung einer Logikfunktion;

wobei der Gesundheitszustand einer der folgenden ist:
ein Fehler in der Stromleitung und eine Störung auf einer Sekundärseite des VT;
eine Ausgangsschnittstelle zum Erzeugen eines Blockiersignals zum Blockieren der Erzeugung eines Auslösesignals durch das Schutzrelais, um den Leistungsschalter auf der Grundlage des ermittelten Zustands der Störung auf der Sekundärseite des VT auszulösen.

5. Überwachungsrelais nach Anspruch 4, wobei das Überwachungsrelais eine im Schutzrelais konfigurierte virtuelle Vorrichtung ist.

6. Überwachungsrelais nach Anspruch 4 oder 5, wobei eine Spannungsfunktion aus den mindestens zwei Spannungsfunktionen und der mindestens einen Stromfunktion auf der Bestimmung des quadratischen Mittelwerts beruht.

**Revendications**

1. Procédé de supervision d'un transformateur de tension d'instrument (VT, 110)) et de fonctionnement d'au moins un disjoncteur (150) en fonction d'un signal de blocage provenant d'un relais de supervision (100), l'au moins un disjoncteur étant connecté électriquement à un relais de protection (100a) dans un système de distribution d'énergie comprenant une pluralité de composants de distribution d'énergie électrique, le relais de supervision étant interfacé avec le VT et un transformateur de courant d'instrument (CT), dans lequel le VT et le CT sont connectés à une ligne électrique (130) du système de distribution d'énergie pour mesurer respectivement la tension et le courant sur la ligne électrique, le procédé comprenant par le relais de supervision :

la réception d'un signal de tension à partir du VT et d'un signal de courant à partir du CT ;
le calcul avec au moins deux fonctions de tension différentes (210, 220, 230) d'un état de défaut de tension en fonction du signal de tension reçu ;
le calcul avec au moins une fonction de courant (240, 250, 260) d'un état de défaut de courant en fonction du signal de courant reçu ;
la détermination d'un état de santé de la ligne électrique en fonction de l'état de défaut de tension et de l'état de défaut de courant ; dans lequel l'état de santé est un d'un défaut dans la ligne électrique et d'une perturbation dans un côté secondaire du transformateur de tension ; et
la génération d'un signal de blocage pour bloquer la génération d'un signal de déclenchement par le relais de protection afin d'actionner le disjoncteur quand l'état de santé déterminé est la perturbation du côté secondaire du VT.

2. Procédé selon la revendication 1, dans lequel le calcul de l'un quelconque de l'état de défaut de tension ou de l'état de défaut de courant comprend le calcul d'une valeur de grandeur représentative de l'au moins un signal de tension ou de l'au moins un signal de courant et la comparaison d'une différence entre la valeur de grandeur représentative calculée dans un premier demi-cycle et celle du demi-cycle suivant, à un seuil prédéfini, dans lequel la valeur de grandeur représentative est une valeur quadratique moyenne.

**3.** Procédé selon l'une des revendications précédentes, dans lequel la détermination d'un état de santé de la ligne électrique comprend la consolidation de l'état de défaut de tension provenant des au moins deux fonctions de tension et de l'état de défaut de courant provenant de l'au moins une fonction de courant, dans lequel au moins une fonction de tension des au moins deux fonctions de tension est fournie avec une pondération plus élevée pour déterminer l'état de santé de la ligne électrique.

**4.** Système comprenant :

une ligne électrique (130),
un disjoncteur (150) connecté à la ligne électrique,
un transformateur de tension d'instrument (VT, 110)) agencé pour mesurer la tension sur la ligne électrique,
un transformateur de courant d'instrument (CT, 120)) agencé pour mesurer le courant sur la ligne électrique,
un relais de protection (100a) et un relais de supervision (100), tous deux connectés au côté secondaire du VT et du CT,
le relais de protection génère un signal de déclenchement pour actionner le disjoncteur en fonction des signaux reçus à partir du VT,
le relais de supervision génère un signal de blocage de déclenchement en fonction des signaux reçus à partir du VT et du CT,
le relais de supervision étant apte à surveiller le VT et à fournir un signal de blocage pour actionner le disjoncteur connecté électriquement dans la ligne électrique d'un système de distribution d'énergie par le relais de protection, le relais de supervision comprenant:

une interface d'entrée (200) pour recevoir au moins un signal de tension à partir du VT et au moins un signal de courant à partir du CT ;
une unité de traitement configurée pour déterminer

a) un état de défaut de tension en fonction du signal de tension reçu à l'aide d'au moins deux fonctions de tension (210, 220, 230) ;
b) un état de défaut de courant en fonction du signal de courant reçu à l'aide d'au moins une fonction de courant (240, 250, 260) ;
c) un état de santé de la ligne électrique fondé en fonction de l'état de défaut de tension et de l'état de défaut de courant à l'aide d'une fonction logique, dans lequel l'état de santé est l'un : d'un défaut de la ligne électrique et d'une perturbation d'un côté secondaire du VT ;

une interface de sortie pour générer un signal de blocage afin de bloquer la génération du signal de déclenchement par le relais de protection pour actionner le disjoncteur quand l'état de santé déterminé est la perturbation du côté secondaire du VT.

**5.** Relais de supervision selon la revendication 4, dans lequel le relais de supervision est un dispositif virtuel configuré dans le relais de protection.

**6.** Relais de supervision selon la revendication 4 ou 5, dans lequel une fonction de tension parmi les au moins deux fonctions de tension et l'au moins une fonction de courant sont basées sur la détermination de la valeur quadratique moyenne.

Figure 1

Figure 2

EP 3 830 920 B1

Figure 2a

Figure 2b

receiving a voltage signal from a voltage transformer and a current signal from a current transformer — 310

calculating with two voltage functions a voltage fault status based on the received voltage signal — 320

calculating with a current function a current fault status based on the received current signal — 330

determining a health condition of the power line as a) a fault in the power line, and b) a disturbance in a secondary of the voltage transformer — 340

generating at least one output signal for blocking operation of the circuit breaker on determined disturbance in the secondary of the voltage transformer and supporting in generating a trip signal to operate the circuit breaker on determined fault condition. — 350

300

Figure 3

EP 3 830 920 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008034400 A1
- CN 103513145 B
- CN 104393674 A
- JP 2000262097 A